# EUROPEAN PATENT APPLICATION

(11) **EP 0 636 586 A1**
(43) Date of publication of application: **01.02.1995**
(21) Application number: 94401660.9
(22) Date of filing: 19.07.1994
(51) Int. Cl.: C03C 3/06, C03B 32/00, G02B 1/00, G03F 1/14

(54) **Photomask substrate plate of synthetic fused silica glass for photolithography**

(30) Priority: 30.07.1993 JP 190143/93
(71) Applicant: SHIN-ETSU CHEMICAL CO., LTD., Chiyoda-ku Tokyo (JP); SHIN-ETSU QUARTZ PRODUCTS CO., LTD., Shinjuku-ku, Tokyo (JP)
(72) Inventor: Ohtsuka, Hisatoshi, Joetsu-shi, Niigata-ken (JP); Takita, Masatoshi, Joetsu-shi, Niigata-ken (JP); Fujinoki, Akira, Kooriyama-shi, Fukushima-ken (JP)
(74) Representative: Armengaud Ainé, Alain

(57) **Abstract**

A photomask substrate plate of synthetic fused silica glass for use in photolithography can be imparted with remarkably improved stability relative to the transmissivity to ultraviolet light and to the dimensional changes due to so-called "radiation compaction" under irradiation, in particular, with ultraviolet light of short wavelength, such as the light emitted from an ArF excimer laser, when the content of molecular hydrogen in the fused silica glass is in the range from 1×10¹⁷ to 1×10¹⁹ molecules/cm³. The content of molecular hydrogen can be controlled within the specified range by suitably selecting the conditions used in the preparation of silicon dioxide by the direct flame hydrolysis method and the annealing treatment.

## Description

### BACKGROUND OF THE INVENTION

The present invention relates to a photomask substrate plate of synthetic fused silica glass for photolithography used in the patterning work for the manufacture of various kinds of electronic devices or, more particularly, the invention relates to a photomask substrate plate of synthetic fused silica glass capable of exhibiting outstandingly high stability in the light transmissivity and dimensional stability even when the photomask is used for the patternwise exposure of a resist layer to ultraviolet light by using an excimer laser as the light source.

As is well known, the recent trend in the manufacturing process of fine electronic devices such as semiconductor silicon-based ICs, LSIs and the like toward a higher and higher degree of integration largely depends on the progress in the photolithographic patterning technology for the formation of a patterned resist layer on the surface of a substrate such as a semiconductor silicon wafer so that pattern resolution in a submicron-order fineness is required for the photolithographic patterning. Since the photolithographic patterning work involves a step of patternwise exposure of the resist layer to light through a pattern-bearing transparency called a photomask, one of the limiting factors for the pattern resolution is the wavelength of the light for the patternwise exposure, which must be as short as possible for the finest pattern resolution. In this regard, there is also a trend that conventional ultraviolet light sources are under continuous replacement with an excimer laser such as KrF and ArF excimer lasers emitting ultraviolet light of a shorter wavelength.

Needless to say, an optical system with such short-wavelength ultraviolet light can be constructed only by using a material having an extremely high transparency to the short-wavelength ultraviolet as the material for the lenses, prisms and the like as well as for the photomask substrate plate when the optical system is for the photolithographic patterning. In this regard, fused silica glass is the only material suitable for use in an optical system with short-wavelength ultraviolet light although fused silica glass is not always quite satisfactory for the purpose depending on the quality. For example, fused silica glass prepared by melting natural quartz crystals has a relatively low transmissivity to the ultraviolet light in a wavelength region of 250 nm or shorter along with a problem of instability against irradiation with ultraviolet light to cause appearance of an absorption band in the wavelength region of 300 nm or shorter resulting in a further decrease in the transmissivity to ultraviolet. Accordingly, the fused silica glass currently under use in an optical system with short-wavelength ultraviolet is mostly prepared from synthetic silica in view of the high transmissivity to ultraviolet and high homogeneity as well as excellent stability against ultraviolet irradiation as the characteristics thereof.

Since it is understood that absorption of light by a fused silica glass body is a consequence of the impurities contained in the glass, it is a natural requirement that the starting material for the preparation of synthetic fused silica glass, which is a volatile silicon compound such as a silane compound, has a purity as high as possible so that the silane compound such as silicon tetrachloride and methyl trimethoxy silane is used after purification by repeating precision distillation.

Several methods are known for the preparation of synthetic fused silica glass from such a purified silane compound including the direct flame method, soot method, plasma method, sol-gel method and the like. These different methods for the preparation of fused silica glass naturally result in greatly diversified properties of the fused silica glass products relative to the physical properties, chemical compositions in the contents of hydroxyl groups, chlorine atoms and the like, structural defects and others so that their behavior in the irradiation with ultraviolet light from an excimer laser is influenced in greatly different ways relative to the light transmissivity or absorption, emission of fluorescence, accuracy of the surface of a glass body and so on according to the reports presented in various scientific meetings and appearing in various scientific journals.

It is generally accepted that appearance of an absorption band in synthetic fused silica glass under irradiation with ultraviolet light, for example, from an excimer laser is a result of the conversion of the intrinsic defects by oxygen deficiency or oxygen excess due to the anomalous linkages, such as ≡Si-OH, ≡Si-Cl, ≡Si-Si≡, ≡Si-O-O-Si≡ and the like, contained in the fused silica glass into paramagnetic defects by the photoreaction. Many reports are found in literatures on the paramagnetic defects including the E' center, i.e. Si·, non-bridge oxygen hole center (NBOHC), i.e. Si-O·, and the like. Synthetic fused silica glass has a strong absorption band of the E' center among these defects in the vicinity of the wavelength of 215 nm or 260 nm due to the paramagnetic defects. The ultraviolet absorption in these wavelength regions is a particularly serious problem when ultraviolet irradiation is performed by using an excimer laser.

In connection with the change caused in the light transmissivity of synthetic fused silica glass under irradiation with ultraviolet light of an excimer laser, it is reported by Nakamura et al. in 1991 that the method for the preparation of the synthetic fused silica glass is an important factor affecting the changes of the synthetic fused silica glass caused in the initial stage of the ultraviolet irradiation by using an ArF excimer laser emitting ultraviolet of 193 nm wavelength with a photon energy of 6.4 eV which is high as compared even with other excimer lasers. Similar results have been obtained in the experiments undertaken by the inventors. For example, when a photomask substrate plate of fused silica glass prepared from synthetic fused silica glass obtained by the direct flame method is irradiated with ultraviolet from an ArF excimer laser, the transmissivity of the glass to the ultraviolet is decreased at the initial stage immediately after start of the irradiation while the transmissivity, after reaching a minimum value, turns to increase by further continuing the ultraviolet irradiation gradually resuming the initial value while such an increase in the transmissivity after initial decrease is not exhibited in the synthetic fused silica glass obtained by the plasma method or soot method by continuing ultraviolet irradiation with an ArF excimer laser so that these methods are not considered to be suitable for the preparation of synthetic fused silica glass from which photomask substrate plates for photolithography using an ArF excimer laser are prepared.

It has been proposed in Japanese Patent Kokai 3-88742 and 3-88743 and U.S. Patent 5,086,352 that the stability of synthetic fused silica glass against irradiation with ultraviolet light from an excimer laser can be improved by adequately controlling the content of hydrogen contained in the fused silica glass at around 5 × 10¹⁶ molecules/cm³. This method is indeed effective to some extent when an optical element such as lenses, prisms and the like is to be imparted with increased resistance against irradiation with ultraviolet from an excimer laser.

While the above mentioned patent documents teach that the content of hydrogen in the synthetic fused silica glass should be within a range in order to impart improved ultraviolet resistance, it has been found that such a teaching is not always applicable to the synthetic fused silica glass as a material of photomask substrate plates for photolithography when the photomask is used with ultraviolet light from an excimer laser. Directing their attention to this problem, the inventors have conducted extensive investigations with an object to obtain a photomask substrate plate of synthetic fused silica glass capable of being used under excimer laser irradiation. Basically, photolithographic photomasks are quite different from other optical elements such as lenses, prisms and the like in their dimensions by having a small thickness of only a few millimeters at the largest so that they are relatively insensitive to the decrease in the light transmissivity while they are under very strict requirements relative to the dimensional stability or, in particular, warping and shrinkage in order to ensure accuracy of the extremely fine circuit pattern formed on the plate by baking. No information is available in the above mentioned patent documents on the range of content of hydrogen which synthetic fused silica glass should contain when a photomask substrate plate prepared from the glass is to be used under excimer laser irradiation.

### SUMMARY OF THE INVENTION

The present invention accordingly has an object to provide a novel photomask substrate plate of synthetic fused silica glass for photolithography capable of exhibiting excellent stability not only relative to the transmissivity to ultraviolet light but also relative to the dimensional stability under irradiation with ultraviolet light even when the light source is an excimer laser by solving the above described problems in the prior art.

Thus, the present invention provides a photomask substrate plate for photolithography which is a plate body made from synthetic fused silica glass containing hydrogen in the molecular form in a content in the range from 1 × 10¹⁷ to 1 × 10¹⁹ molecules/cm³ or, preferably, in the range from 2 × 10¹⁸ to 7 × 10¹⁸ molecules/cm³.

### BRIEF DESCRIPTION OF THE DRAWING

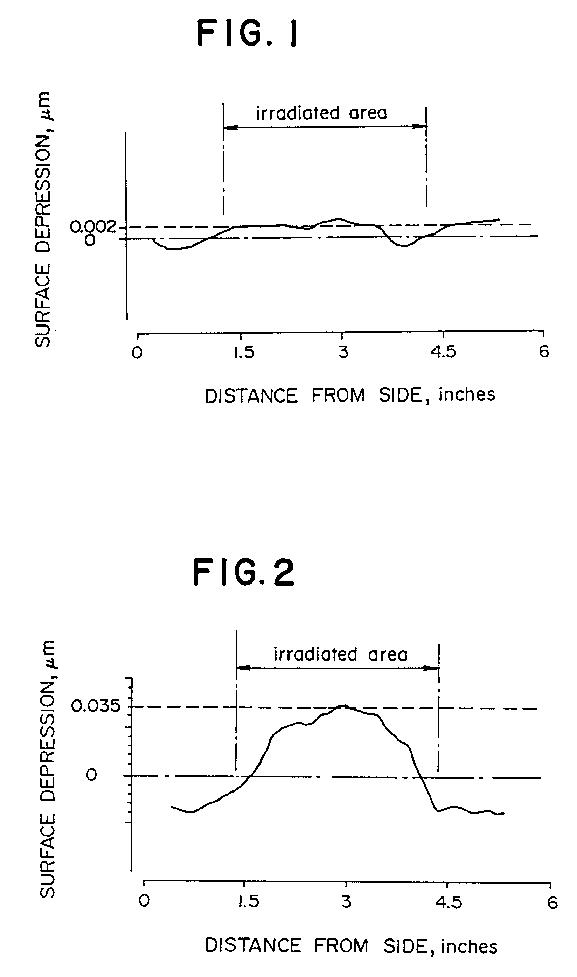

Figures 1 and 2 are each a graph showing the distribution of surface depression caused by the ultraviolet irradiation of a photomask substrate plate of synthetic fused silica glass (see Example 4 and Comparative Example 2, respectively).

### DETAILED DESCRIPTION OF THE PREFERRED EMBODIMENTS

In view of the above described information relative to the stability of light transmissivity in synthetic fused silica glass prepared by different methods under irradiation with ultraviolet light from an ArF excimer laser, it was the first choice of the inventors to use synthetic fused silica glass prepared by the direct flame method rather than that by the plasma method or soot method as a material of photomask substrate plates of the invention for photolithography. A problem therein was, however, that considerable variations were noted in the change of transmissivity in the initial stage of ultraviolet irradiation among different lots or within one and the same lot of the glass products even when the procedure of the direct flame method was identical so as not to afford confirmation of the stability in the optical properties. In addition, while it is indispensable that the synthetic fused silica glass body as prepared by the direct flame method is subjected to an annealing treatment before the glass body is worked and shaped into a photomask substrate plate, a great decrease is caused by the annealing treatment in the content of hydrogen in the glass sometimes reaching 70% based on the content before the annealing treatment so that it is a difficult matter to obtain synthetic fused silica glass containing hydrogen in a well controlled content within a narrow range.

Besides efforts directed to the problem of the transmissivity to ultraviolet light, the inventors have further continued their investigations on the dimensional stability of a photomask substrate plate of synthetic fused silica glass for photolithography arriving at a discovery that the dimensional instability of fused silica glass under irradiation with ultraviolet light from an excimer laser is a consequence mainly of the shrinkage of the fused silica glass called "radiation compaction" and the radiation compaction is subject to considerable variations, like the changes in the transmissivity, among lots or within one and the same lot of the glass products and further depends on the conditions of the annealing treatment or other thermal treatments.

The unexpectedly novel discovery obtained in the above described investigations leading to the present invention is that a photomask substrate plate of synthetic fused silica glass for photolithography, when used under irradiation with ultraviolet light emitted from an excimer laser, is imparted with greatly improved stability not only relative to the light transmissivity showing only a small decrease in the transmissivity at the initial stage of the ultraviolet irradiation as well as a small change in the transmissivity per se after prolonged irradiation but also relative to the dimensions of the substrate plate to be freed from the radiation compaction when and only when the content of molecular hydrogen contained in the silica glass is within the above mentioned range of from 1 × 10¹⁷ to 1 × 10¹⁹ molecules/cm³ or, preferably, in the range from 2 × 10¹⁸ to 7 × 10¹⁸ molecules/cm³ based on a novel discovery that the content of molecular hydrogen is the most important factor which influences the dimensional stability of a photomask substrate plate of synthetic fused silica glass.

When the content of molecular hydrogen contained in the synthetic fused silica glass is too large, the decrement in the transmissivity at the initial stage of the ultraviolet irradiation is increased although improvements can be obtained in the stability of the transmissivity and in the dimensional stability of the photomask substrate plate under prolonged ultraviolet irradiation using an excimer laser. When the content of molecular hydrogen contained in the synthetic fused silica glass is too small, on the other hand, a decrease is caused in the decrement of the transmissivity at the initial stage though with improvements in the stability of the transmissivity *per se* and the dimensional stability. A good balance of these parameters can be obtained only when the content of molecular hydrogen in the fused silica glass is within the above described range. Further, it is another conclusion obtained by the above mentioned investigations that the variation in the transmissivity over the whole surface area of the photomask substrate plate and deformation of the patterned image formed by the patternwise exposure through the photomask can be within practically admissible ranges when the distribution of the content of molecular hydrogen is so uniform over the whole area of the substrate plate that the difference between the largest value and the smallest value of the hydrogen content, shown by the symbol ΔH₂, does not exceed a certain upper limit of, for example, 40% of the largest value. When the photomask substrate plate of synthetic fused silica glass satisfies the above described requirements, namely, a prolonged irradiation with ultraviolet light from an ArF excimer laser and the like causes only a very small decrease in the dimensional accuracy of the substrate plate which can retain substantially the accuracy before the ultraviolet irradiation along with a relatively small decrease in the light transmissivity at the initial stage of the ultraviolet irradiation as well as early recovery of the transmissivity from the minimum value as the turning point.

As is mentioned above, the synthetic fused silica glass body as the base material of the inventive photomask substrate plate is prepared by the direct flame method known *per se* in the prior art. The starting material of the silica glass used in the direct flame method is a volatile silane compound represented by the general formula RₙSiX₄₋ₙ, in which R is a monovalent hydrocarbon group, X is a hydrolyzable group and the subscript n is zero or a positive integer not exceeding 4. The silane compound in the form of a vapor is introduced into a nozzle of a concentrically multitubular burner of fused silica glass and subjected to flame hydrolysis in an oxyhydrogen flame on the burner nozzle to produce very fine particles of silicon dioxide, called a silica soot, which are deposited on a rotating refractory base body forming a porous body of silicon dioxide deposit which, as grown, is directly vitrified into a transparent silica glass body by heating in the oxyhydrogen flame.

When the content of molecular hydrogen in the thus obtained transparent fused silica glass body is required to be within a specific range, it is important first of all that the vapor of the silane compound is introduced together with oxygen gas into the center nozzle of the concentrically multitubular burner in such an adequately specified proportion of the silane gas to the oxygen gas that the content of molecular hydrogen in the silica glass plate prepared by subjecting the fused silica glass body to annealing, slicing, grinding and polishing is in the range from 1 × 10¹⁷ to 1 × 10¹⁹ molecules/cm³ or, preferably, in the range from 2 × 10¹⁸ to 7 × 10¹⁸ molecules/cm³ to be suitable as a photomask substrate plate for photolithography under irradiation with ultraviolet light from an excimer laser.

Containing molecular hydrogen in the above specified range, the photomask substrate plate thus obtained has advantages that, when it is irradiated with ultraviolet light from an ArF excimer laser having a wavelength of 193 nm or photon energy of 6.4 eV, which is relatively high among excimer lasers, exhibits improved dimensional stability during prolonged ultraviolet irradiation although the transmissivity of the glass to ultraviolet light of 193 nm is rapidly decreased at the initial stage of the ultraviolet irradiation shortly reaching a minimum value as a turning point from which the transmissivity starts to increase. Needless to say, this advantageous behavior of the inventive photomask substrate plate in the ultraviolet irradiation is exhibited in the ultraviolet irradiation not only from the above mentioned ArF excimer laser but also from other excimer lasers emitting in a longer wavelength or with lower photon energy including KrF excimer lasers having a wavelength of 248 nm or photon energy of 4.8 eV, XeBr excimer lasers having a wavelength of 282 nm or photon energy of 4.4 eV and XeF excimer lasers having a wavelength of 353 nm or photon energy of 3.5 eV.

In an experiment to test the stability of the light transmissivity of photomask substrate plates under ultraviolet irradiation in relation to the content of molecular hydrogen therein, it was found that a substrate plate prepared from synthetic fused silica glass containing 5 × 10¹⁸ molecules/cm³ of molecular hydrogen showed only 1.0% or less of a decrement in the transmissivity to the ultraviolet light of 193 nm wavelength at the initial stage of ultraviolet irradiation when the plate was irradiated with 1 × 10⁵ shots of pulsed ultraviolet light of 193 nm wavelength from an ArF excimer laser working at a frequency of 100 Hz with an energy density of 20 mJ/cm² per pulse over the circular center area of about 75 mm diameter. On the other hand, a similar test conducted with another photomask substrate plate containing 1 × 10¹⁷ molecules/cm³ or less of molecular hydrogen indicated that the decrement in the transmissivity to the ultraviolet light was 2 to 3% when the plate was irradiated with 1 × 10⁵ shots of pulsed ultraviolet light of 193 nm wavelength from an ArF excimer laser working at a frequency of 100 Hz with an energy density of 100 mJ/cm² per pulse. These experimental results support the conclusion that the content of molecular hydrogen in the photomask substrate plate of the invention must be at least 1 × 10¹⁷ molecules/cm³.

In another experiment to test the dimensional stability of photomask substrate plates of synthetic fused silica glass, a 6.3 mm thick substrate plate containing 5 × 10¹⁶ molecules/cm³ of molecular hydrogen was irradiated with 1 × 10⁵ shots of pulsed ultraviolet light from an ArF excimer laser working at a frequency of 100 Hz in an energy density of 100 mJ/cm² per pulse and the depression of the irradiated surface was measured by means of an interferometer utilizing the reflection wave front to find that the thickness shrinkage in the irradiated area was 35 nm. On the other hand, the same irradiation test as above was performed except that the content of molecular hydrogen in the substrate plate was 5 × 10¹⁸ molecules/cm³ to find that the thickness shrinkage in the irradiated area of the plate surface was only one tenth or smaller of the value obtained in the first irradiation test.

The above obtained experimental results provide a support for the requirement that the content of molecular hydrogen in the inventive photomask substrate plate of synthetic fused silica glass must be in the range from 1 × 10¹⁷ to 1 × 10¹⁹ molecules/cm³ or, preferably, in the range from 2 × 10¹⁸ to 7 × 10¹⁸ molecules/cm³.

As is mentioned before, the content of molecular hydrogen in synthetic fused silica glass is decreased when the glass body is subjected to an annealing treatment by 70% at the largest. In order that the content of molecular hydrogen in the photomask substrate plate of synthetic fused silica glass is within the above specified particular range, accordingly, the synthetic fused silica glass body before the annealing treatment should contain molecular hydrogen in a somewhat higher content taking into account the decrement thereof caused by the annealing treatment. For example, a cylindrical block of synthetic fused silica glass having dimensions of 100 mm diameter and 100 mm length and containing molecular hydrogen in a content of 4 × 10¹⁸ to 1 × 10¹⁹ molecules/cm³ can be subjected to an annealing treatment at a temperature in the range from 1000 to 1200 °C for 1 to 50 hours before mechanical working into a photomask substrate plate which contains molecular hydrogen in the specified content. The above mentioned conditions for the annealing treatment also ensure the desired uniformity in the distribution of the molecular hydrogen content within the photomask substrate plate such that the difference between the highest and lowest values of the molecular hydrogen content ΔH₂ within a photomask substrate plate does not exceed 40% of the highest value.

In the following, the advantages obtained in the inventive photomask substrate plate of synthetic fused silica glass are illustrated in more detail by way of examples and comparative examples. In the following experiments, the light transmissivity of the photomask substrate plates was calculated from the ratio of the outgoing light intensity therefrom to the incident light intensity thereinto when the substrate plate is irradiated with ultraviolet light from an ArF excimer laser having a wavelength of 193 nm. The content of molecular hydrogen in the photomask substrate plates was determined Raman-spectrophotometrically in the following manner.

The Raman-spectrophotometric determination of molecular hydrogen was carried out by the host counting method using an argon laser beam of 488 nm wavelength at an output of 700 mW on a Raman spectrophotometer (Model NR 1100, manufactured by Nippon Bunko Kogyo Co.) equipped with a photomultiplier (Model R943-02, manufactured by Hamamatsu Photonics Co.). The content of molecular hydrogen was calculated from the ratio of the peak areas of the scattering band at 800 cm⁻¹ wave number assignable to SiO₂ and the scattering band at 4135 to 4140 cm⁻¹ assignable to hydrogen in the Raman scattering spectrum. The conversion factor of the peak area ratio to the content of hydrogen was that given in a Russian journal Zhurnal Prikladnoi Spektroskopii, volume 46, No. 6, pages 987 to 991 (June, 1987).

### Examples 1 to 3 and Comparative Example 1.

A transparent block of synthetic fused silica glass was prepared by the direct flame method in which vapor of methyl trimethoxy silane as the starting material of silica was introduced into and flame-hydrolyzed in an oxyhydrogen flame to deposit the fine silica particles on a refractory base into a porous deposit of silica particles which was *in situ* vitrified into a cylindrical transparent glass block. Thereafter, this block was sliced into discs which were subjected to hot-molding, annealing treatment, grinding and polishing into 6 inches by 6 inches square photomask substrate plates having a thickness of 6.3 mm. The content of molecular hydrogen in the thus prepared fused silica glass plates was controlled in the range from 4 to 10 × 10¹⁸ molecules/cm³ by adequately selecting the feed rates of the silane vapor, hydrogen gas and oxygen gas.

The thus prepared substrate plates of synthetic fused silica glass in Examples 1 to 3 and Comparative Example 1 containing molecular hydrogen in contents of 5 × 10¹⁸ molecules/cm³, 6 × 10¹⁸ molecules/cm³, 7 × 10¹⁸ molecules/cm³ and 2 × 10¹⁹ molecules/cm³, respectively, were each subjected to 1 × 10⁴ shots of a pulse-wise irradiation test with ultraviolet light of 193 nm wavelength from an ArF excimer laser at a frequency of 100 Hz in an energy density of 20 mJ/cm² per shot and the decrements of the transparency were determined to give values of 0.72%, 0.87%, 1.00% and 1.20%, respectively.

### Example 4 and Comparative Example 2.

Two more photomask substrate plates having the same dimensions as in the preceding examples were prepared by the same method. The content of molecular hydrogen was 5 × 10¹⁸ molecules/cm³ in one of the two (Example 4) and 5 × 10¹⁶ molecules/cm³ in the other (Comparative Example 2). These substrate plates were each subjected to 1 × 10⁵ shots of a pulse-wise irradiation test with ultraviolet light of 193 nm wavelength from an ArF excimer laser at a frequency of 100 Hz in an energy density of 100 mJ/cm² per shot and the depression of the surface at the center within the irradiated area was measured by the reflection method using an interferometer to give the results shown in Figures 1 and 2, respectively. As is clear from these figures, the surface depression in Example 4 is approximately 0.002 µm or smaller throughout the irradiated area while the surface depression in Comparative Example 2 is much larger reaching 0.035 µm at the largest indicating that the lower limit of the desirable molecular hydrogen content in the substrate plate is somewhere between 5 × 10¹⁸ molecules/cm³ and 5 × 10¹⁶ molecules/cm³ or around 1 × 10¹⁷ molecules/cm³.

## Claims

1. A photomask substrate plate for photolithography which is a plate body made from a synthetic fused silica glass containing hydrogen in the molecular form in a content in the range from 1 × 10¹⁷ to 1 × 10¹⁹ molecules/cm³.

2. The photomask substrate plate for photolithography as claimed in claim 1 in which the content of hydrogen in the molecular form in the synthetic fused silica glass is in the range from 2 × 10¹⁸ to 7 × 10¹⁸ molecules/cm³.

3. The photomask substrate plate for photolithography as claimed in claim 1 in which the difference in the content of hydrogen in the molecular form between the largest value and the smallest value does not exceed 40% of the largest value.
